# EUROPEAN PATENT SPECIFICATION

(11) **EP 3 167 494 B1**
(45) Date of publication and mention of the grant of the patent: **02.10.2019**
(21) Application number: 14783994.8
(22) Date of filing: 10.07.2014
(51) Int. Cl.: H01L 33/52, H01L 33/58

(54) **METHOD AND INSTALLATION FOR MANUFACTURE OF LIGHT EMITTING DIODES**
VERFAHREN UND INSTALLATION ZUR HERSTELLUNG VON LICHTEMITTIERENDEN DIODEN
PROCÉDÉ ET INSTALLATION DE FABRICATION DE DIODES ÉLECTROLUMINESCENTES

(43) Date of publication of application: 17.05.2017
(73) Proprietor: "Octa Light Bulgaria" AD, 1202 Sofia (BG)
(72) Inventor: ILIEV, Iliya, 1680 Sofia (BG)
(74) Representative: Lekova, Tatyana Boyanova
(86) International application number: PCT/BG2014/000026
(87) International publication number: WO 2016/004487

(56) References cited:
- US-A- 5 498 444
- US-A1- 2005 001 228
- US-A1- 2010 181 901
- US-A1- 2012 326 341

## Description

### Technical Field

This invention relates to a method and installation for manufacturing of light emitting diodes and finds application in varied field of technologies, were light emitting diodes are manufactured and applied, as for example, in lighting installations.

### Technical Background

In the manufacturing of a light emitting diode, over a chip is mounted a primary optic system (lens), which has two main goals: to encapsulate the LED and to protect it from the harmful effects of the surrounding environment, as well as to increase the overall light emission and form the final LED light emission angle.

As by today, the lens is realized by means of silicate materials or silicones. In the production of a lens with silicate materials, the lens is formed separately by forming equipment (by injection or compression methods), and is later attached on top of the semiconductor chip. The produced in such a way light emitting diode is characterized by low quality of the optical system (lens) and the technology is with low production rates, mainly due to the, most of the time manual, attachment of the formed lens over the semiconductor chips. The attachment of the lens over the chip does not assure the necessary quality for the light emitting diode, as there is a possibility for de-attachment of the lens, as well as entrapment of epoxy attaching material or air between the emission layer of the light emitting diode and the lens.

When the lens is made by silicones, it is formed directly over the semiconductor chips by injection molding. The injection molding is realized by preliminary realized tools with predefined form and characteristics of the lens. This method is characterized with comparably high initial investment costs due to the need of manufacturing of specific tooling and the need of specialized molding equipment. This method has a good final quality of the product, but also a high manufacturing price. For each change of the lens form, it is necessary to prepare a new and separate tool, which means undertaking a large time and financial investment.

Both the known methods have a main drawback - due to the specifics of the tooling and the used materials, these methods provide only a partial solution to the light emission quests of a light emitting diode with some defined design limits. By these two methods, it is completely impossible to use materials with varied refraction index within one optical system, as the mixing of optical materials during the injection or molding process is by volume and it is thus impossible to create a system with separated layers of materials with varying refraction index

### Summary of the invention

The goal of this invention is to propose a method and an installation for manufacturing of light emitting diodes as disclosed in claim 1, which assures the possibility to solve unlimited and varying optical distributions by using optical materials with varying refraction index and with low production costs.

The goal is reached with a method of manufacturing of light emitting diodes, in which, over a thermally conductive substrate, on which are mounted one or more semiconductor chips, gold wire bonds and light conversion materials, UV light curable optical material is placed. The UV light curable optical material is placed layer by layer, so that it forms a primary optic system (lens) in vertical direction, with every layer being subject to UV light with large wavelength spectrum, and the lighting being applied for a period from 0.01 seconds to 1 minute.

The realized layers can be with a thickness from 20 micrometers to 3 millimeters, as well as with materials with different refraction index.

The goal is reached also by the creation of an installation for manufacturing of light emitting diodes as disclosed in claim 4, including working table, on top of which a substrate is placed, with preliminarily mounted semiconductor chips, wire bonding of the chips and light wavelength conversion material, characterized by the fact, that the installation includes a UV Printer, including a series of pico-jet print heads, having each varied nozzles, which assure a varied angle of jetting of optical materials with varying viscosity. The UV printer includes also a UV light emission source, mounted in a way that assure horizontal movement on the longitudinal side of the printer, with the jetting heads and the UV light emission source being connected to a computing block, to which a monitor and video camera for initial positioning of the working table of the UV printer are connected.

The advantages of the method and the installation according to the invention are:
- Compared to the known methods for placement of lenses over the light emitting diodes, such as attachment of pre-made lenses or molding of silicone materials under pressure in preliminary made tools and instruments, the method according to this invention gives freedom in the elaboration of the final lens form and design, permitting, by software engineering, to realize over one and the same substrate two adjacent light emitting diodes having two different optical systems (lenses);
- The investments in tooling and equipment become unnecessary and a series of processes such as molding, extrusion and metal working for special tooling production are not any more required;
- The final price of the manufactured light emitting diode is lowered due to the removal of a series of processes requiring time and materials;
- The timing from design to series production of light emitting diodes is seriously lowered, without passing through a time taking process of prototyping and optimization;
- Varied optical distribution requirements can be realized without the need of additional secondary optics thanks to the possibility of manufacturing free-form optical structures, which brings to the removal of secondary optics and to the lowering of the final costs of lighting systems.

### Description of attached figures

Figure 1 shows the vertical structure of a light emitting device consisting of multiple light emitting diodes manufactured by the method described by this invention;
Figure 2 schematically shows the vertical structure of a light emitting diode, manufactured by the method according to this invention;
Figure 3 is a block schematic of the installation according to this invention.

### Examples for the realization of this invention

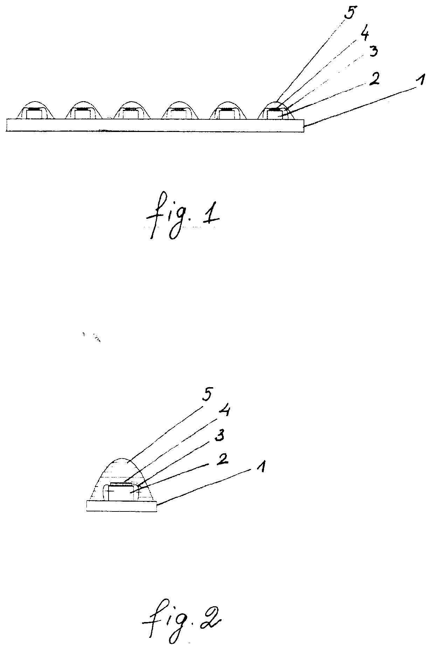

The light emitting diode, realized according to the method described in this invention (fig. 1 and 2), includes a substrate (1), over which a semiconductor chip (2) is placed and wire bonding (3) is realized. Over the semiconductor chip (2) is placed light wavelength conversion material (4). Over the semiconductor chip (2), wiring (3) and wavelength conversion material (4) is created a vertically layered structure of the primary optic (5) (lens) of the light emitting diode.

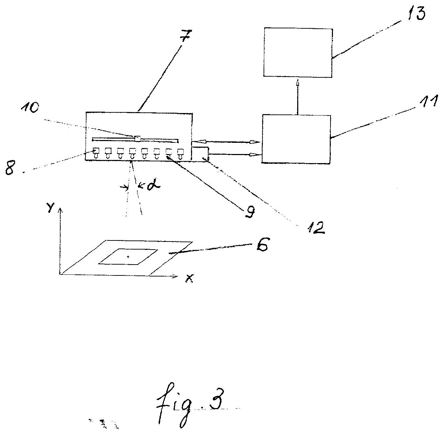

The installation for manufacturing of light emitting diodes (fig. 3) includes a working table (6), over which a UV printer (7) is displaced, including pico-jet heads (8) with varied nozzles (9). The UV printer includes also a UV light emission source (10), mounted with the possibility of horizontal movement through the entire length of the UV printer (7). The controlling of the pico-jet heads (8) and the UV light source (10) are connected to a computing block (11), which is connected to a video camera (12) for initial positioning of the work table (6) and to monitor (13)

The nozzles (9) of the pico-jet heads (8) can be directed to an angle **α** compared to the level of the working table (6) by controlling signals from the computing block (11). The nozzles (9) of the pico-jet heads (8) can be displaced at a distance from the work table surface varying from 0.1 to 100 millimeters.

### Method of usage of the invention

The manufacturing of light emitting diodes or strips based on light emitting diodes according to the method described by this invention is realized by placing over a working table (6) of a thermally conductive substrate (1) with wire bonded semiconductor chip (2), over which light wavelength conversion material (4) is placed. Through the image, received from a video camera (12), which is displayed over a monitor (13), manual alignment of the working table (6) towards the center of the UV printer (7) is realized over X and Y coordinate axes. Afterwards, from the computing block (11) a signal towards a specific pico-jet head (8) is given, so that it activates over the semiconductor chip (2), the wire bonding (3) and the light wavelength converting material (4) and places the first layer of the new optical system (5). For the semiconductor chips (2), which have bigger dimension, until reaching the overall height of the chip-wire bonding-light wavelength conversion material, the jetting of optical material of the lens is stopped within the area of the bigger semiconductor chip (2) in order to avoid both material spilling and change of the final form and quality of the formed lens (5). The computing block (11) chooses which pico-jet head (8) to be activated according to a preliminarily set schematic of switching of the jet heads (8), which depends from the specific final optical system which has to be created. The separate pico-jet heads (8) are loaded with optically clear, varied viscosity and refraction index materials. After placement of the first layer of the optical system (5) (lens), this layer is lighted for a preliminarily set period of time (again depending from the specific characteristics of the lens which has to be realized) by activation from the computing block (11) of the UV range light (10), with the computing system (11) defining the specific wavelength of the emitted UV light.

The time for UV-light curing of the material placed by the pico-jet heads (8) can vary from 0,01 seconds to 1 minute, the quantity of the jetted material can vary from 1 microgram to 10 grams, the jetted quantity in a specific point can vary from 1 pico liter to 100 milliliters, the speed of movement of the pico-jet head (8) can vary from 0.1 to 100 mm/second, the delay or waiting time for the curing of the jetted material with UV light following the jetting process itself can be from 0,1 seconds to 10 minutes.

For some optical materials it is also necessary to realize a thermal curing procedure after their placement, which can be arrive to temperatures of 150 degree Celsius. Thus, thanks to such a production installation according to this invention, not only separate layers of a lens (5) can be realized, but also within the layer itself, zones with different lighting characteristics can be created. This gives the practical possibility to realize light emitting diodes with varied parameters of light emission angles, light intensity, light distributions and other similar characteristics which are specific for light emitting diodes and strips based on light emitting diodes.

The invention is applicable for the encapsulation of light emitting diodes and makes easier the realization of customized optical systems (lenses). By the use of high quality materials, this invention removes the need of secondary optics over the light emitting diodes, thus rising the efficiency of systems based on light emitting diodes by lowering the light losses due to secondary optics. Complex optical systems can be created, both as a form and structure, by the multi-layering method of vertically controlled growing of the lens (5). The used materials for the creation of the lens (5) are a key factor, where the appropriate materials are similar to silicones and the main materials can be diluted with less viscose products in ratios varying from 1:1 to 1:100.

## Claims

1. Method for manufacturing Light Emitting Diodes (LED) including the steps of:
- forming a lens (5) over a thermally conductive substrate (1) of the LED (2) by means of multilayer placement of materials with variable size, viscosity and/or refraction index, said substrate being placed on a working table (6), comprising the the steps of:
- forming the lens (5) layer by layer, wherein the lens (5) is formed in vertical direction with pre-defined form and thickness of each layer, and sequence of material type of the layers;
- forming each layer as to contain one or more types of material;
- curing each layer by UV light to form the final lens (5) so as to obtain the pre-defined shape and form of a layer which serves as a basis for the next layer in the final lens (5);
the method being **characterised in that**,
- applying each material of each layer at a variable angle (α) of placement, said angle (α) being defined with respect to a normal direction (Y) to the working table, using materials with varying viscosity and controlling the time of exposure to external UV light in the range from 0,001 second to 1 minute, in order to obtain pre-defined form of each layer.

2. Method according to claim 1, **characterized in that** the final lens (5) is realized by deposition of multiple layers, each with varying thickness from 20 micrometers to 3 millimeters.

3. Method for manufacturing according to claims 1 or 2, wherein the final lens (5) is made of materials with different refraction indexes along its height.

4. Installation for manufacture of Light Emitting Diodes, including a working table (6), on top of which a substrate is placed (1), with preliminarily mounted semiconductor chips (2), wire bonding of the chips (3) and light wavelength conversion material (4), **characterized by** that it includes a UV Printer (7), including a series of pico-jet print heads (8), having each varied nozzles (9), each assuring a varied angle of jetting of the optical material with varying viscosity, wherein the UV printer (7) includes as well an UV light emission source (10), mounted in a way to assure horizontal movement on longitudinal side of the printer (7), with the jetting heads (8) and the UV light emission source (10) being connected to a computer block (11), to which a monitor (13) and video camera (12) for initial positioning of the working table (6) of the UV printer (7) are connected.

5. Installation for manufacturing of Light Emitting Diodes, according to claim 4, **characterized by** the fact that the nozzles (9) of the pico-jet heads (8) are mounted with the possibility of varying the angle α of placement of the optical material.

6. The installation for manufacturing of Light Emitting Diodes, according to claim 4 or 5, **characterized by** that, the pico-jet heads (8) are loaded with optical material with varied viscosity, varied sensitivity to UV exposure light, varied thermal-curing characteristics and varied refraction index.

## Patentansprüche

1. Verfahren zur Herstellung von Lichtemissionsdioden (LED) mit den folgenden Schritten:
- Ausbilden einer Linse (5) auf dem wärmeleitenden Substrat (1) der LED (2) durch mehrschichtiges Aufbringen von Materialien mit variabler Größe, Viskosität und/oder Brechungsindex, wobei das Substrat auf einen Arbeitstisch (6) gelegt wird, umfassend die folgenden Schritte:
schichtweises Ausbilden der Linse (5), wobei die Linse (5) in vertikaler Richtung mit vordefinierter Form und Dicke jeder Schicht und Reihenfolge der verwendeten Materialart für jede aufgebrachte Schicht ausgebildet ist;
Bilden jeder Schicht, um eine oder mehrere Arten von Material zu enthalten;
Aushärten jeder Schicht durch UV-Licht, um die endgültige Linse (5) zu bilden, um die vordefinierte Form und Gestalt jeder Schicht zu erhalten, die als Grundlage für die nächste Schicht in der endgültigen Linse (5) dient;
indem das Verfahren **dadurch gekennzeichnet ist, dass**
- die Aufbringung jeder Materialart jeder Schicht in einem variablen Anordnungswinkel (α) erfolgt, wobei der erwähnte Winkel (α) in Bezug auf eine normale Richtung (Y) zum Arbeitstisch definiert ist, wobei Materialien mit variierender Viskosität verwendet werden und die Zeit der externen UV-Lichteinwirkung im Bereich von 0,001 Sekunden bis 1 Minute gesteuert wird, um eine vordefinierte Form jeder Schicht zu erhalten.

2. Verfahren nach Anspruch 1, **dadurch gekennzeichnet, dass** die endgültige Linse (5) durch Abscheidung mehrerer Schichten mit jeweils unterschiedlicher Dicken von 20 Mikrometern bis 3 Millimetern realisiert wird.

3. Verfahren zur Herstellung nach Anspruch 1 oder 2, wobei die endgültige Linse (5) aus Materialien mit unterschiedlichen Brechungsindizes entlang ihrer Höhe hergestellt ist.

4. Installation zur Herstellung von Lichtemissionsdioden mit einem Arbeitstisch (6), auf dem ein Substrat (1), mit vormontierten Halbleiterchips (2), Drahtbonden der Chips (3) und Lichtwellenlänge-Konversionsmaterial (4) angeordnet ist, **dadurch gekennzeichnet, dass** es einen UV-Drucker (7) umfasst, der eine Reihe von Pico-Jet-Druckköpfen (8) umfasst, die jeweils unterschiedliche Düsen (9) aufweisen, die jeweils einen unterschiedlichen Strahlwinkel des optischen Materials mit variierender Viskosität sicherstellen, wobei der UV-Drucker (7) auch eine UV-Lichtemissionsquelle (10) enthält, die so angebracht ist, dass sie eine horizontale Bewegung auf der Längsseite des Druckers (7) gewährleistet, mit den Strahlköpfen (8) und der UV-Lichtemissionsquelle (10) an einen Computerblock (11) angeschlossen, an den ein Monitor (13) und eine Videokamera (12) zur anfänglichen Positionierung des Arbeitstisches (6) des UV-Druckers (7) angeschlossen sind.

5. Installation zur Herstellung von Lichtemissionsdioden nach Anspruch 4, **dadurch gekennzeichnet, dass** die Düsen (9) der Pico-Jet-Köpfe (8) mit der Möglichkeit montiert sind, den Anordnungswinkel α des optischen Materials zu variieren.

6. Installation zur Herstellung von Lichtemissionsdioden nach Anspruch 4 oder 5, **dadurch gekennzeichnet, dass** die Pico-Jet-Köpfe (8) mit optischem Material unterschiedlicher Viskosität, unterschiedlicher Empfindlichkeit gegenüber UV-Licht, unterschiedlicher Eigenschaften der thermischen Aushärtung und variierter Brechungsindizes beladen sind.

## Revendications

1. Procédé de fabrication de diodes électroluminescentes comprenant les étapes suivantes :
- former une lentille (5) sur un substrat thermoconducteur (1) de la DEL (2) au moyen d'un placement multicouches de matériaux à taille, viscosité et/ou indice de réfraction variables, ledit substrat étant placé sur une table de travail (6), comprenant les étapes suivantes :
former couche par couche la lentille (5), la lentille (5) étant formée dans une direction verticale avec forme et épaisseur prédéfinies de chaque couche et une séquence de type de matériau des couches ;
former chaque couche de manière à contenir un ou plusieurs types de matériau ;
durcir chaque couche par la lumière UV pour former la lentille finale (5) afin d'obtenir la forme prédéfinie et la forme d'une couche qui sert de base à la couche suivante dans la lentille finale (5) ;
le procédé étant **caractérisée en ce que**
- chaque matériau de chaque couche est appliqué selon un angle de placement (α) variable, ledit angle (α) étant défini par rapport à une direction normale (Y) à la table de travail, en utilisant des matériaux à viscosité variable et en contrôlant le temps d'exposition à la lumière UV externe dans la plage de 0,001 seconde à 1 minute, afin d'obtenir une forme prédéfinie de chaque couche.

2. Procédé selon la revendication 1, **caractérisé en ce que** la lentille finale (5) est réalisée par dépôt de multiples couches, chacune d'une épaisseur variable de 20 micromètres à 3 millimètres.

3. Procédé de fabrication selon les revendications 1 ou 2, où la lentille finale (5) est faite de matériaux ayant des indices de réfraction différents tout au long de sa hauteur.

4. Installation pour la fabrication de diodes électroluminescentes, comprenant une table de travail (6) sur laquelle est placé un substrat (1), avec des puces semi-conductrices montées préalablement (2), câblage par fil des puces (3) et matériau de conversion de la longueur d'onde de la lumière (4), **caractérisée en ce qu'**elle comprend une imprimante UV (7), comprenant une série de têtes d'impression pico-jet (8), ayant chacune des buses variées (9), chacune assurant un angle varié de projection du matériau optique de viscosité variable, l'imprimante UV (7) comprenant également une source d'émission de lumière UV (10) montée de manière à assurer un mouvement horizontal sur le côté longitudinal de l'imprimante (7), avec les têtes de projection (8) et la source d'émission de lumière UV (10) étant connectées à un bloc informatique (11), auquel sont connectés un moniteur (13) et une caméra vidéo (12) pour le positionnement initial de la table de travail (6) de l'imprimante UV (7).

5. L'installation selon la revendication 4, **caractérisée en ce que** les buses (9) des têtes pico-jet (8) sont montées avec la possibilité de faire varier l'angle a de placement du matériau optique.

6. L'installation selon la revendication 4 ou 5, **caractérisée en ce que** les têtes pico-jet (8) sont chargées d'un matériau optique à viscosité variée, de sensibilité variée à la lumière d'exposition UV, caractéristiques de durcissement thermique variées et indice de réfraction varié.
